# EUROPEAN PATENT APPLICATION

(11) **EP 4 700 775 A1**
(43) Date of publication of application: **25.02.2026**
(21) Application number: 23940117.7
(22) Date of filing: 08.06.2023
(51) Int. Cl.: G11C 11/408

(54) **STORAGE CIRCUIT AND PREPARATION METHOD THEREFOR, AND MEMORY AND ELECTRONIC DEVICE**

(71) Applicant: Huawei Technologies Co., Ltd., Shenzhen, Guangdong 518129 (CN)
(72) Inventor: ZHANG, Wenqiang, Shenzhen, Guangdong 518129 (CN); HUANG, Kailiang, Shenzhen, Guangdong 518129 (CN); YIN, Shihui, Shenzhen, Guangdong 518129 (CN); JING, Weiliang, Shenzhen, Guangdong 518129 (CN); WANG, Zhengbo, Shenzhen, Guangdong 518129 (CN); LIAO, Heng, Shenzhen, Guangdong 518129 (CN)
(74) Representative: Maiwald GmbH
(86) International application number: PCT/CN2023/099126
(87) International publication number: WO 2024/250231

(57) **Abstract**

This application discloses a memory circuit, a preparation method thereof, a memory, and an electronic device. A three-terminal 2T0C memory cell is formed based on a dual-gate transistor. A second transistor used as a read transistor is set as the dual-gate transistor. A first control electrode (namely, a first gate) of the second transistor is configured to store written data during a write operation, and a second control electrode (namely, a second gate) of the second transistor is configured to control a current path between a bit line and a read word line. During the write operation, a cut-off voltage may be loaded to the read word line connected to the second control electrode of the second transistor, to control the second transistor to be turned off, and the current path between the bit line and the read word line may be blocked during the write operation, to avoid a possibility of generating a large current in a memory array, so that the three-terminal 2T0C memory cell can implement a large-scale array. **In** comparison with a four-terminal 2T0C memory cell, complexity and an area of SA routing are reduced, and storage density can be effectively improved.

## Description

### TECHNICAL FIELD

This application relates to the field of circuit design technologies, and in particular, to a memory circuit and a preparation method thereof, a memory, and an electronic device.

### BACKGROUND

Currently, mainstream dynamic random access memory (dynamic random-access memory, DRAM) products are mainly implemented based on a one-transistor-one-capacitor (1-transistor-1-capacitor, 1T1C) memory cell. A DRAM memory based on a two-transistor-zero-capacitor (2-transistor-0-capacitor, 2T0C) cell has separate read and write terminals, and therefore has an advantage of implementing a non-destructive read operation. In addition, the 2T0C memory cell uses a parasitic capacitor as a storage node (storage node, SN), and no independent capacitor device needs to be disposed. Therefore, a complex capacitor process is not required, and process difficulty can be reduced. However, the 2T0C memory cell has short data retention time due to the small parasitic capacitor. A transistor based on an oxide semiconductor material has a very small quiescent current, is very suitable for the 2T0C memory cell, and can effectively improve the data retention time of the 2T0C memory cell.

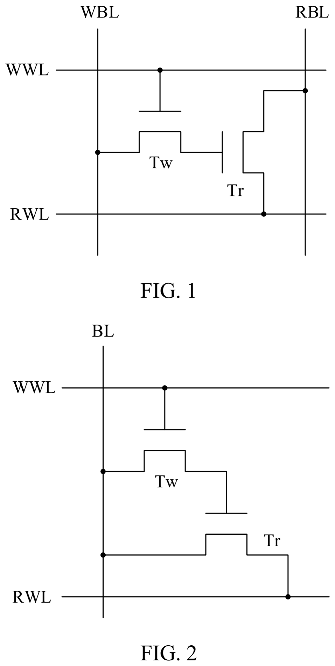

As shown in FIG. 1, a current 2T0C memory cell is mainly a four-terminal device, that is, includes four terminals: a write word line (write word line, ) WWL, a read word line (read word line, RWL), a write bit line (write bit line, WBL), and a read word line (read bit line, RBL). In a standby (standby) , the WBL, the WWL, the RBL, and the RWL are all at low voltages. For a write operation, the WWL needs to be set to a high voltage, a write transistor is turned on, and a WBL voltage iswritten as a gate of a read transistor of a storage node. For a read operation, the RBL is first pre-charged to a high voltage, and then the RWL is pulled from a high voltage to a low voltage. If data stored in the SN is "1" (high voltage), the RBL voltage decreases, and may be amplified through a sense amplifier (sensing amplifier, SA) connected to the RBL, and the RBL is pulled to a low level. In this case, a result on the RBL can be read.

Because the WBL and RBL terminals are separated in the four-terminal 2T0C memory cell, the SA requires a large quantity of physical layout traces, and routing difficulty is high. Therefore, a more advanced metal interconnection process is required, and a requirement on a process capability is high. As shown in FIG. 2, in a three-terminal 2T0C memory cell, a WBL and an RBL may be combined into a bit line (bit line, BL), so that a routing requirement is reduced.

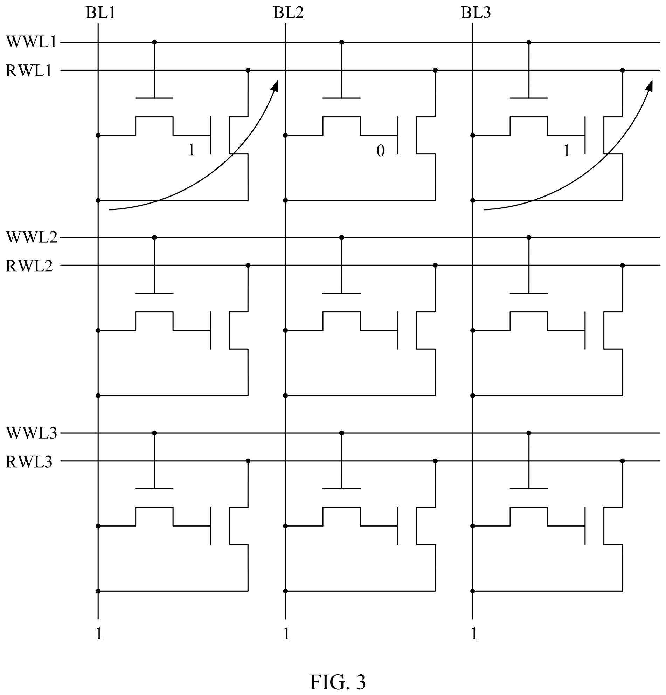

As shown in FIG. 3, a memory array (also referred to as a memory circuit) is formed by using the three-terminal 2T0C memory cell. For a write operation, when a WWL is set to a high voltage for turning on, if original data in the 2T0C memory cell is "1", there is a current path from a BL to an RWL. If data written by the BL is "1", a large current exists between the BL and the RWL, which easily causes a very large current of the memory array. Based on thisTherefore, a large-scale array cannot be implemented by using the existing three-terminal 2T0C memory cell, and storage density cannot be effectively improved.

### SUMMARY

This application provides a memory circuit and a preparation method thereof, a memory, and an electronic device, to improve storage density.

According to a first aspect, this application provides a memory circuit, and the memory circuit may include a plurality of memory cells, a plurality of write word lines, a plurality of read word lines, and a plurality of bit lines. At least one of the plurality of memory cells includes a first transistor used as a write transistor and a second transistor used as a read transistor, and the second transistor is a double-gate transistor. In the memory cell, a first electrode of the first transistor and a first electrode of the second transistor are both connected to a same bit line in the plurality of bit lines, a second electrode of the first transistor is connected to a first control electrode of the second transistor, a first control electrode of the first transistor is connected to one of the plurality of write word lines, and a second electrode and a second control electrode of the second transistor are both connected to one of the plurality of read word lines. It should be noted that the first electrode and the second electrode of the transistor mentioned in this application each may be either a source (source) or a drain (drain). In addition, the first electrode of the first transistor and the first electrode of the second transistor may be both sources or both drains, or one is a source and the other is a drain. For example, the drain of the first transistor and the drain of the second transistor may be both connected to a bit line, the source of the first transistor is connected to the first control electrode of the second transistor, and the source of the second transistor and the second control electrode of the second transistor are both connected to a read word line. For another example, the source of the first transistor and the drain of the second transistor may be both connected to a bit line, the drain of the first transistor is connected to the first control electrode of the second transistor, and the source of the second transistor and the second control electrode of the second transistor are both connected to a read word line. No exhaustive description is provided herein.

The memory circuit provided in this application includes a three-terminal 2T0C memory cell that is based on a dual-gate transistor, and the second transistor used as the read transistor is set as the dual-gate transistor. The dual-gate transistor is a device that can change Vt of the dual-gate transistor by regulating a voltage of one of gates (namely, a control electrode). In the three-terminal 2T0C memory cell, the first control electrode (namely, a first gate) of the second transistor is configured to store written data during a write operation, and the second control electrode (namely, a second gate) of the second transistor is configured to control a current path between the bit line and the read word line. During the write operation, a cut-off voltage (generally a low voltage) may be loaded to the read word line connected to the second control electrode of the second transistor, to control the second transistor to be turned off, and the current path between the bit line and the read word line may be blocked during the write operation, to avoid a possibility of generating a large current in a memory array. In this way, the three-terminal 2T0C memory cell can implement a large-scale array. In comparison with a four-terminal 2T0C memory cell, complexity and an area of SA routing are reduced, and storage density can be effectively improved.

In some embodiments of this application, the first transistor in the memory cell may be a single-gate transistor. In other words, the first transistor has only one control electrode (namely, a gate). In this case, the memory cell includes a single-gate transistor and a dual-gate transistor.

In some other embodiments of this application, to further regulate leakage of the write transistor, namely, the first transistor, the first transistor may be disposed as a double-gate transistor. In this case, the memory cell includes two double-gate transistors. Correspondingly, the memory circuit may further include a plurality of write back gates, and the plurality of write back gates may be connected to each other. The second control electrode of the first transistor may be connected to one of the plurality of write back gates, and a fixed voltage may be loaded to the second control electrode of the first transistor through the write back gate, to regulate leakage of the first transistor. Especially in a standby stage, using a double-gate transistor as the first transistor helps reduce leakage.

When performing a write operation, the memory circuit provided in this embodiment of this application may perform the write operation on each memory cell connected to one or more write word lines. For example, data is written to three memory cells in a 1^{st} row. In response to a write instruction, a specific process of performing the write operation is as follows: All the read word lines are set to a second voltage, for example, "0", so that a second transistor connected to each read word line is turned off, and a current path between each bit line and each read word line is blocked, to avoid a possibility of generating a large current in the memory array. In this way, the three-terminal 2T0C memory cell can implement a large-scale array. In comparison with the four-terminal 2T0C memory cell, complexity and an area of SA routing are reduced, and storage density can be effectively improved. A selected write word line is set to a first voltage, for example, "1", so that a first transistor connected to the selected write word line is turned on. For example, write word lines in the 1^{st} row are set to "1", so that first transistors in the memory cells in the 1^{st} row are turned on. Another write word line is set to the second voltage, for example, "0", so that a first transistor connected to the another write word line is turned off. For example, write word lines in a 2^{nd} row and a 3^{rd} row are set to "0", so that first transistors in memory cells in the 2^{nd} row and the 3^{rd} row are turned off. Each bit line is controlled to be set to the first voltage or the second voltage based on data that needs to be written. Specifically, for a memory cell to which data needs to be written is "0", a bit line is set to "0". For example, bit lines in a 1^{st} column and a 3^{rd} column are set to "0", so that data written to the 1^{st} and 3^{rd} memory cells in the 1^{st} row is "0". For a memory cell to which data needs to be written is "1", a bit line is set to "1". For example, bit lines in a 2^{nd} column are set to "1", so that data written to the 2^{nd} memory cell in the 1^{st} row is "1".

When performing a read operation, the memory circuit provided in this embodiment of this application may perform a read operation on each memory cell connected to a read word line. For example, data in the three memory cells in the 1^{st} row is read. In response to a read instruction, a specific process of performing the read operation is as follows: Each bit line is pre-charged to a third voltage, for example, a half voltage between "0" and "1". All the write word lines are set to a second voltage, for example, "0", so that the first transistor connected to each write word line is turned off. A selected read word line is set to the first voltage, for example, "1", so that a second transistor connected to the selected read and write word line is turned on. For example, read word lines in the 1^{st} row are set to "1", so that second transistors in the memory cells in the 1^{st} row are turned on. Another read word line is set to the second voltage, for example, "0", so that a second transistor connected to the another read word line is turned off. For example, read word lines in the 2^{nd} row and the 3^{rd} row are set to "0", so that second transistors in memory cells in the 2^{nd} row and the 3^{rd} row are turned off. A voltage change of each bit line is amplified through a sense amplifier. Specifically, for a memory cell whose stored data is "0", a voltage of a bit line remains unchanged. For example, if voltages of bit lines in the 1^{st} column and the 3^{rd} column remain unchanged, data stored in the 1^{st} and 3^{rd} memory cells in the 1^{st} row may be read as "0". For a memory cell whose stored data is "1", a voltage of a bit line increases. For example, if voltages of bit lines in the 2^{nd} column increase, data stored in the 2^{nd} memory cell in the 1^{st} row may be read as "1".

The foregoing describes the read and write operations of the memory circuit by using the memory circuit in which a memory cell includes a single-gate transistor and a dual-gate transistor. A difference in read and write operations of the memory circuit in which a memory cell includes two dual-gate transistors lies in that each write back gate is set to a fixed voltage, to regulate leakage of each first transistor. In addition, fixed voltages loaded to each write back gate in different operations may be the same or may be different. For example, in the standby stage, each write back gate is set to the second voltage, for example, "0", to reduce leakage of the first transistor. When the write operation is performed, each write back gate is set to the first voltage, for example, "1", so that the first transistor can be quickly turned on to write data.

In this embodiment of this application, to reduce an area of the memory cell, the first transistor and the second transistor that form the memory cell may be stacked on a substrate. In this case, the plurality of write word lines and the plurality of read word lines may be arranged in a first direction parallel to the substrate, and the plurality of bit lines may be arranged in a second direction perpendicular to the substrate. The foregoing descriptions are provided by using an example in which the first transistor is a single-gate transistor. When the first transistor is a double-gate transistor, the write back gates may also be arranged in the first direction parallel to the substrate.

In a memory cell, a second transistor is disposed on the substrate, a first transistor may be stacked on the second transistor. In other words, the first transistor is stacked on the second transistor, and the first transistor and the second transistor may be located on a same side of a connected bit line. For example, the first transistor and the second transistor may be located on a right side of the bit line. Alternatively, in a memory cell, a second transistor may be stacked on a first transistor. This is not limited herein. The following uses an example in which the first transistor is stacked on the second transistor for description.

For ease of routing, the first control electrode of the second transistor may be set as a top gate, and the second control electrode of the second transistor may be set as a back gate. In other words, the first control electrode of the second transistor is located above the first electrode and the second electrode of the second transistor, and the second control electrode of the second transistor and the read bit line are both located below the first electrode and the second electrode of the second transistor. Specifically, the second transistor may include a first gate layer, a first gate dielectric layer, a first oxide semiconductor layer, a second gate dielectric layer, and a second gate layer that are sequentially stacked on the substrate. The first gate layer includes the second control electrode of the second transistor and the read word line, the second gate layer includes the first control electrode of the second transistor as an SN, the first oxide semiconductor layer includes the first electrode, a channel, and the second electrode of the second transistor, and the second electrode of the second transistor is connected to the second control electrode of the second transistor through a first interconnection metal structure.

When the first transistor is a single-gate transistor, the first transistor may be of a top-gate structure. To be specific, the first control electrode of the first transistor and the write word line are both located above the first electrode and the second electrode of the first transistor. Specifically, the first transistor may include a third gate dielectric layer, a second oxide semiconductor layer, a fourth gate dielectric layer, and a third gate layer that are sequentially stacked on the second transistor. In addition, an insulation layer is further disposed between the first transistor and the second transistor. The third gate layer includes the first control electrode of the first transistor and the write word line, the second oxide semiconductor layer includes the first electrode, a channel, and the second electrode of the first transistor, and the second electrode of the first transistor is connected to the first control electrode of the second transistor through a second interconnection metal structure.

When the first transistor is a double-gate transistor, the first control electrode of the first transistor may be a top gate, and the second control electrode of the first transistor may be a back gate. To be specific, the first control electrode of the first transistor and the write word line are both located above the first electrode and the second electrode of the first transistor, and the second control electrode of the first transistor and the write back gate are both located below the first electrode and the second electrode of the first transistor. Specifically, the first transistor may include a fourth gate layer, a third gate dielectric layer, a second oxide semiconductor layer, a fourth gate dielectric layer, and a third gate layer that are sequentially stacked on the second transistor. In addition, an insulation layer is further disposed between the first transistor and the second transistor. The third gate layer includes the first control electrode of the first transistor and the write word line, the fourth gate layer includes the second control electrode of the first transistor and the write back gate, the second oxide semiconductor layer includes the first electrode, a channel, and the second electrode of the first transistor, and the second electrode of the first transistor is connected to the first control electrode of the second transistor through a second interconnection metal structure.

In the memory cell, the first interconnection metal structure and the second interconnection metal structure may be disposed on a same side of stacked film layers (the film layers include the first gate layer, the first gate dielectric layer, the first oxide semiconductor layer, the second gate dielectric layer, the second gate layer, the insulation layer, the third gate dielectric layer, the second oxide semiconductor layer, the fourth gate dielectric layer, and the third gate layer). The bit line is vertically disposed on another side of the film layers, and the bit line is connected to the first electrode of the first transistor and the first electrode of the second transistor.

In this embodiment of this application, to implement three-dimensional array storage, the memory cells in the memory circuit may form a plurality of memory layers stacked on the substrate, and each memory layer may include a plurality of memory cells arranged in an array. At a memory layer, memory cells in each row are arranged in an extension direction of a read word line and a write word line, namely, the first direction, and memory cells in each column are arranged in a third direction perpendicular to the first direction. In each row of memory cells, the memory cells may be connected to a same read word line and a same write word line. The bit line extends in a direction perpendicular to the memory layer, namely, the second direction. Therefore, at different memory layers, memory cells located in a same position in the second direction may be connected to a same bit line.

In some embodiments of this application, memory cells in each row at a memory layer may be arranged in a same manner. In other words, memory cells in each row and each column are arranged in a same direction, and at the memory layer, the memory cells are arranged in a mosaic (mosaic) form.

In some other embodiments of this application, to reduce area overheads of the memory layer and improve array storage density, memory cells in every two adjacent rows at the memory layer may be arranged in a mirror manner, and two memory cells in adjacent columns share a same bit line. In other words, in each row of memory cells, the memory cells are arranged in a same direction. At the memory layer, two memory cells in adjacent columns are arranged in the mirror manner, and the memory cells are arranged in a back-to-back (back to back) form.

The foregoing describes how to implement three-dimensional array storage by using the memory circuit in which a memory cell includes a single-gate transistor and a dual-gate transistor. A difference in implementing three-dimensional array storage by the memory circuit in which a memory cell includes two dual-gate transistors lies in that: A dielectric layer is added, that is, when a part of the dielectric layers are selectively etched for the first time, an etched dielectric layer is added, and when each gate layer is formed through one-step deposition, the fourth gate layer may be further formed, where the fourth gate layer includes the second control electrode of the first transistor and the write back gate that are connected to each other. A write back gate whose extension direction is the same as that of the read word line and the write word line is added. In other words, the write back gate is arranged in the first direction y. In each row of memory cells, the memory cells may be further connected to a same write back gate. In addition, the write back gates may be connected to each other.

In this embodiment of this application, a peripheral circuit may be further integrated around a plurality of memory layers of the memory circuit. The peripheral circuit may specifically include: a first lead line configured to lead down (pick down) the plurality of write word lines and a second lead line configured to pick down the plurality of read word lines, a sense amplifier that is disposed below the plurality of memory layers and that is connected to the plurality of bit lines, a write sub-word line driver that is disposed on one side of the sense amplifier and that is connected to the plurality of write word lines through the first lead line, and a read sub-word line driver that is disposed on another side of the sense amplifier and that is connected to the plurality of read word lines through the second lead line, where the leads are respectively disposed on two sides of the plurality of memory layers. The read sub-word line driver is disposed below the second lead line, and the write sub-word line driver is disposed below the first lead line, so that an area of the peripheral circuit can be reduced, and storage density can be improved.

In this embodiment of this application, the plurality of memory layers share the sense amplifier, and different memory cells are selected by using the write sub-word line driver and the read sub-word line driver to perform a read operation.

Specifically, in response to the write operation, the write sub-word line driver may control a selected write word line to be set to the first voltage, to control a first transistor connected to the selected write word line to be turned on, and control another write word line to be set to the second voltage, to control a first transistor connected to the another write word line to be turned off; the read sub-word line driver may control all the read word lines to be set to the second voltage, to control second transistors connected to all the read word lines to be turned off; and the sense amplifier circuit may control, based on data that needs to be written, each bit line to be set to the first voltage or the second voltage.

Specifically, in response to the read operation, the sense amplifier may control each bit line to be pre-charged to the third voltage, namely, the half voltage; the write sub-word line driver may control all the write word lines to be set to the second voltage, to control first transistors connected to all the write word lines to be turned off; the read sub-word line driver may control a selected read word line to be set to the first voltage, to control a second transistor connected to the selected read word line to be turned on, and control another read word line to be set to the second voltage, to control a second transistor connected to the another read word line to be turned off; and the sense amplifier circuit may amplify a voltage change of each bit line, to read stored data.

The foregoing describes the peripheral circuit of the memory circuit by using the memory circuit in which a memory cell includes a single-gate transistor and a dual-gate transistor. A difference in a peripheral circuit of the memory circuit in which a memory cell includes two dual-gate transistors lies in that a gate driver connected to each write back gate is added, and the gate driver may control each write back gate to be set to a fixed voltage.

According to a second aspect, this application provides a memory circuit preparation method, including: forming a plurality of memory cells, a plurality of write word lines, a plurality of read word lines, and a plurality of bit lines. At least one of the plurality of memory cells includes a first transistor and a second transistor, and the second transistor is a double-gate transistor. In the memory cell, a first electrode of the first transistor and a first electrode of the second transistor are both connected to a same bit line in the plurality of bit lines, a second electrode of the first transistor is connected to a first control electrode of the second transistor, a first control electrode of the first transistor is connected to one of the plurality of write word lines, and a second electrode and a second control electrode of the second transistor are both connected to one of the plurality of read word lines.

In some embodiments of this application, the first transistor may be a single-gate transistor. In this case, the memory cell may be prepared by using the following technical process. The technical process specifically includes the following steps.
(1) A plurality of dielectric layers are epitaxially grown. For example, six dielectric layers may be formed by using materials such as SiO, SiN, AlO, Si, and SiGe.
(2) A part of the plurality of dielectric layers are selectively etched on one side of the dielectric layers. For example, a 1^{st} dielectric layer, a 3^{rd} dielectric layer, and a 6^{th} dielectric layer may be selectively etched rightward by using an atom-level etch (atom-level etch, ALE) process.
(3) A first gate layer, a second gate layer, and a third gate layer are formed through one-step deposition, and then a dielectric is formed through two-step deposition. The first gate layer includes the second control electrode of the second transistor and the read word line, the second gate layer includes the first control electrode of the second transistor as an SN, and the third gate layer includes the first control electrode of the first transistor and the write word line.
(4) Another part of the plurality of dielectric layers are selectively etched on the same side of the dielectric layers. For example, a 2^{nd} dielectric layer and a 5^{th} dielectric layer may be selectively etched rightward by using the ALE.
(5) A first gate dielectric layer, a second gate dielectric layer, a third gate dielectric layer, and a fourth gate dielectric layer are formed through one-step deposition, and then a first oxide semiconductor layer and a second oxide semiconductor layer are formed through two-step deposition. The first oxide semiconductor layer includes the first electrode, a channel, and the second electrode of the second transistor, and the second oxide semiconductor layer includes the first electrode, a channel, and the second electrode of the first transistor.
(6) Another part of the plurality of dielectric layers are selectively etched on another side of the dielectric layers. For example, the 1^{st} dielectric layer, the 2^{nd} dielectric layer, the 4^{th} dielectric layer, and the 5^{th} dielectric layer may be selectively etched leftward in another direction by using the ALE.
(7) A metal is deposited, to form a first interconnection metal structure used to connect the second electrode of the second transistor and the second control electrode of the second transistor, and form a second interconnection metal structure used to connect the second electrode of the first transistor and the first control electrode of the second transistor. Specifically, the first interconnection metal structure and the second interconnection metal structure may include one or more film layers. This is not limited herein.
(8) Optionally, doping may be performed on a left side of the first oxide semiconductor layer and the second oxide semiconductor layer, and the doping may improve subsequent contact performance between a bit line and an oxide semiconductor material.
(9) A metal is deposited on one side of the plurality of dielectric layers to form a bit line used to connect the first electrode of the first transistor and the first electrode of the second transistor.

The foregoing describes the memory cell preparation process by using a memory circuit in which a memory cell includes a single-gate transistor and a dual-gate transistor. A difference in a preparation process of a memory circuit in which a memory cell includes two dual-gate transistors lies in that: A dielectric layer is added, that is, when a part of the dielectric layers are selectively etched for the first time, an etched dielectric layer is added, and when each gate layer is formed through one-step deposition, a fourth gate layer may be further formed, where the fourth gate layer includes the second control electrode of the first transistor and a write back gate that are connected to each other.

According to a third aspect, this application provides a memory. The memory includes a controller and the memory circuit provided in the first aspect of this application, and the controller is configured to access the memory circuit.

According to a fourth aspect, this application provides an electronic device, including a circuit board and the memory provided in the third aspect of this application. The memory is electrically connected to the circuit board, and the electronic device may further include another chip or an independent device.

### BRIEF DESCRIPTION OF DRAWINGS

To describe the technical solutions in embodiments of this application or in the background more clearly, the following briefly describes the accompanying drawings for describing embodiments of this application or the background.
FIG. 1 is a circuit diagram of a current four-terminal 2T0C memory cell;
FIG. 2 is a circuit diagram of a current three-terminal 2T0C memory cell;
FIG. 3 is a circuit diagram of a memory array formed by a current three-terminal 2T0C memory cell;
FIG. 4a is a circuit diagram of a memory cell in a memory circuit according to an embodiment of this application;
FIG. 4b is another circuit diagram of a memory cell in a memory circuit according to an embodiment of this application;
FIG. 5a is a circuit diagram of a memory circuit according to an embodiment of this application;
FIG. 5b is another circuit diagram of a memory circuit according to an embodiment of this application;
FIG. 6a is a diagram of performing a write operation by a memory circuit according to an embodiment of this application;
FIG. 6b is a diagram of performing a read operation by a memory circuit according to an embodiment of this application;
FIG. 7a is a diagram of stacking of a memory cell in a memory circuit according to an embodiment of this application;
FIG. 7b is another diagram of stacking of a memory cell in a memory circuit according to an embodiment of this application;
FIG. 8a is a diagram of a structure of a memory cell in a memory circuit in an xz direction according to an embodiment of this application;
FIG. 8b is another diagram of a structure of a memory cell in a memory circuit in an xz direction according to an embodiment of this application;
FIG. 9 is a diagram of a structure of the memory cell having the structure shown in FIG. 8a after each step in a preparation process is completed;
FIG. 10a is a diagram of a structure of a memory circuit in an xy direction according to an embodiment of this application;
FIG. 10b is a diagram of a cross-sectional structure in an AA direction in FIG. 10a;
FIG. 10c is a diagram of a cross-sectional structure in an BB direction in FIG. 10a;
FIG. 11a is another diagram of a structure of a memory circuit in an xy direction according to an embodiment of this application;
FIG. 11b is a diagram of a cross-sectional structure in an AA direction in FIG. 11a;
FIG. 11c is a diagram of a cross-sectional structure in an BB direction in FIG. 11a;
FIG. 12a is a diagram of an overall structure of a peripheral circuit of a memory circuit according to an embodiment of this application;
FIG. 12b is a diagram of a specific structure of a peripheral circuit of a memory circuit according to an embodiment of this application;
FIG. 13 is a diagram of a structure of a memory according to an embodiment of this application; and
FIG. 14 is a diagram of a structure of an electronic device according to an embodiment of this application.

### DESCRIPTION OF EMBODIMENTS

To make the objectives, technical solutions, and advantages of this application clearer, the following further describes this application in detail with reference to the accompanying drawings.

Terms used in the following embodiments are merely intended to describe specific embodiments, but are not intended to limit this application. As used in the specification and appended claims of this application, the terms "a", "one", "the", "the foregoing", "this", and "the one" of singular forms are intended to also include plural forms, for example, "one or more", unless otherwise clearly specified in the context.

Reference to "one embodiment", "some embodiments", or the like described in this specification means that a specific feature, structure, or characteristic described with reference to the embodiment is included in one or more embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "contain", "have", and their variants all mean "include but are not limited to", unless otherwise specifically emphasized.

In addition, same reference numerals in the figures represent same or similar structures. Therefore, repeated description thereof is omitted. Expressions of positions and directions in this application are described by using the accompanying drawings as an example. However, changes may also be made as required, and all the changes fall within the protection scope of this application. The accompanying drawings in this application are merely used to illustrate relative position relationships and do not represent an actual scale.

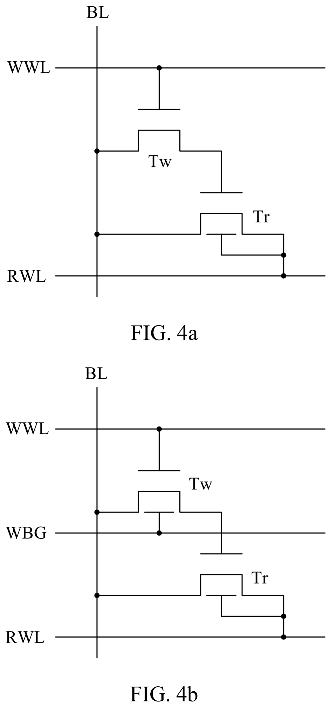

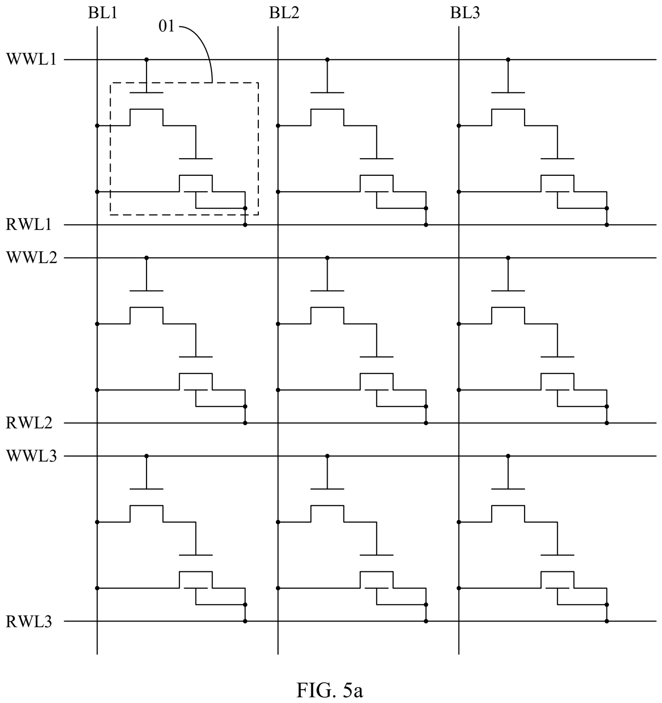

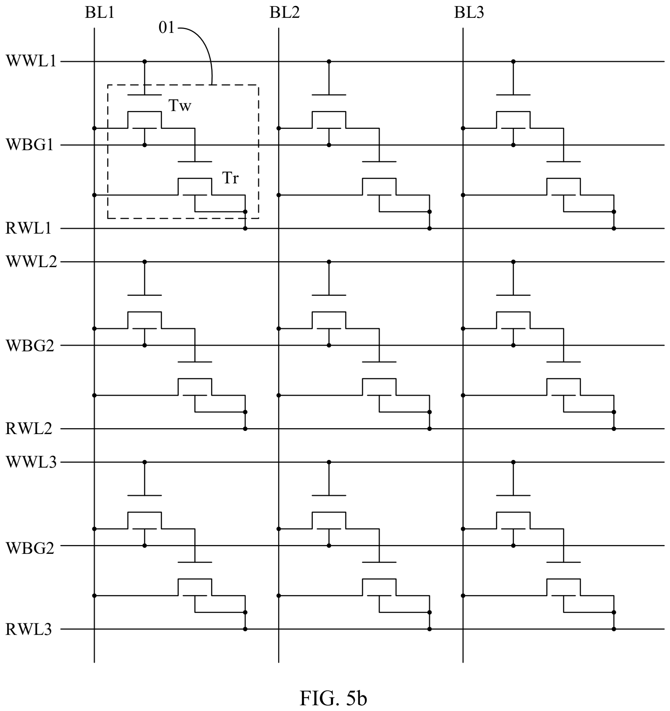

FIG. 4a is a circuit diagram of a memory cell in a memory circuit according to an embodiment of this application. FIG. 4b is another circuit diagram of a memory cell in the memory circuit according to an embodiment of this application. FIG. 5a is a circuit diagram of the memory circuit according to an embodiment of this application. FIG. 5b is another circuit diagram of the memory circuit according to an embodiment of this application.

As shown in FIG. 4a and FIG. 5a, an embodiment of this application provides a memory circuit, specifically including a plurality of memory cells 01, a plurality of write word lines WWLs (WWL1, WWL2, and WWL3), a plurality of read word lines RWLs (RWL1, RWL2, and RWL3), and a plurality of bit lines BLs (BL1, BL2, BL3). At least one of the plurality of memory cells 01 includes a first transistor Tw used as a write transistor and a second transistor Tr used as a read transistor, and the second transistor Tr is a double-gate transistor. In the memory cell 01, a first electrode of the first transistor Tw and a first electrode of the second transistor Tr are both connected to a same bit line BL in the plurality of bit lines BLs, a second electrode of the first transistor Tw is connected to a first control electrode of the second transistor Tr, a first control electrode of the first transistor Tw is connected to one of the plurality of write word lines WWLs, and a second electrode and a second control electrode of the second transistor Tr are both connected to one of the plurality of read word lines RWLs. It should be noted that the first electrode and the second electrode of the transistor mentioned in this application each may be either a source (source) or a drain (drain). In addition, the first electrode of the first transistor Tw and the first electrode of the second transistor Tr may be both sources or both drains, or one is a source and the other is a drain. For example, the drain of the first transistor Tw and the drain of the second transistor Tr may be both connected to a bit line BL, the source of the first transistor Tw is connected to the first control electrode of the second transistor Tr, and the source of the second transistor and the second control electrode of the second transistor are both connected to a read word line RWL. For another example, the source of the first transistor Tw and the drain of the second transistor Tr may be both connected to a bit line BL, the drain of the first transistor Tw is connected to the first control electrode of the second transistor Tr, and the source of the second transistor and the second control electrode of the second transistor are both connected to a read word line RWL. No exhaustive description is provided herein.

The memory circuit provided in this application includes a three-terminal 2T0C memory cell that is based on a dual-gate transistor, and the second transistor Tr used as the read transistor is set as the dual-gate transistor. The dual-gate transistor is a device that can change Vt of the dual-gate transistor by regulating a voltage of one of gates (namely, a control electrode). In the three-terminal 2T0C memory cell, the first control electrode (namely, a first gate) of the second transistor Tr is configured to store written data during a write operation, and the second control electrode (namely, a second gate) of the second transistor Tr is configured to control a current path between the bit line BL and the read word line RWL. During the write operation, a cut-off voltage (generally a low voltage) may be loaded to the read word line RWL connected to the second control electrode of the second transistor Tr, to control the second transistor Tr to be turned off, and the current path between the bit line BL and the read word line RWL may be blocked during the write operation, to avoid a possibility of generating a large current in a memory array. In this way, the three-terminal 2T0C memory cell can implement a large-scale array. In comparison with a four-terminal 2T0C memory cell, complexity and an area of SA routing are reduced, and storage density can be effectively improved.

As shown in FIG. 4a and FIG. 5a, in some embodiments of this application, the first transistor Tw in the memory cell 01 may be a single-gate transistor. In other words, the first transistor Tw has only one control electrode (namely, a gate). In this case, the memory cell 01 includes a single-gate transistor and a dual-gate transistor.

As shown in FIG. 4b and FIG. 5b, in some other embodiments of this application, to further regulate leakage of the write transistor, namely, the first transistor Tw, the first transistor Tw may be disposed as a double-gate transistor. In this case, the memory cell 01 includes two double-gate transistors. Correspondingly, the memory circuit may further include a plurality of write back gates WBGs (write back gate), and the plurality of write back gates WBGs may be connected to each other. The second control electrode of the first transistor Tw may be connected to one of the plurality of write back gates WBGs, and a fixed voltage may be loaded to the second control electrode of the first transistor Tw through the write back gate WBG, to regulate leakage of the first transistor Tw. Especially in a standby stage, using a double-gate transistor as the first transistor Tw helps reduce leakage.

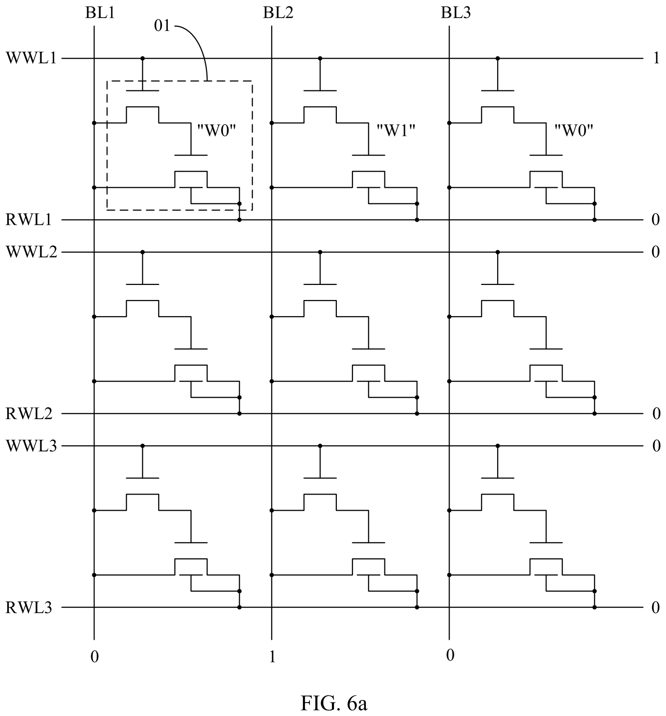

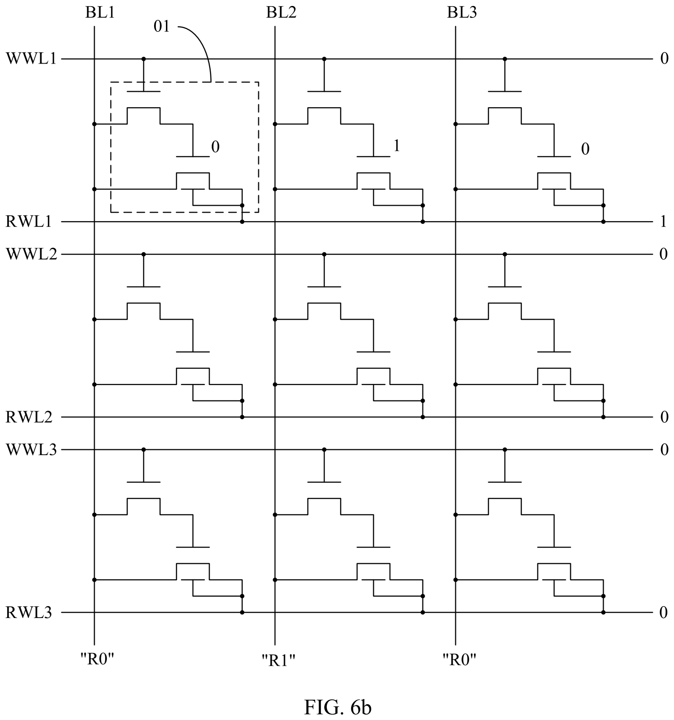

FIG. 6a is a diagram of performing a write operation by the memory circuit according to an embodiment of this application. FIG. 6b is a diagram of performing a read operation by the memory circuit according to an embodiment of this application.

When performing the write operation, the memory circuit provided in this embodiment of this application may perform the write operation on each memory cell connected to one or more write word lines. As shown in FIG. 6a, for example, data is written to three memory cells in a 1^{st} row. A specific write operation process is as follows: All the read word lines RWL1, RWL2, RWL3 are set to a second voltage, for example, "0", so that a second transistor connected to each read word line RWL is turned off, and a current path between each bit line BL and each read word line RWL is blocked, to avoid a possibility of generating a large current in the memory array. In this way, the three-terminal 2T0C memory cell can implement a large-scale array. In comparison with the four-terminal 2T0C memory cell, complexity and an area of SA routing are reduced, and storage density can be effectively improved. A selected write word line WWL is set to a first voltage, for example, "1", so that a first transistor connected to the selected write word line WWL is turned on. For example, the write word line WWL1 is set to "1", so that first transistors in the memory cells in the 1^{st} row are turned on. Another write word line WWL is set to the second voltage, for example, "0", so that a first transistor connected to the another write word line WWL is turned off. For example, write word lines WWL2 and WWL3 are set to "0", so that first transistors in memory cells in a 2^{nd} row and a 3^{rd} row are turned off. Each bit line BL is controlled to be set to the first voltage or the second voltage based on data that needs to be written. Specifically, for a memory cell whose data needs to be written is "0", a bit line BL is set to "0". For example, bit lines BL1 and BL3 are set to "0", so that data written to the 1^{st} and 3^{rd} memory cells in the 1^{st} row is "0" (W0). For a memory cell whose data needs to be written is "1", a bit line BL is set to "1". For example, the bit line BL2 is set to "1", so that data written to the 2^{nd} memory cell in the 1^{st} row is "1" (W1).

When performing the read operation, the memory circuit provided in this embodiment of this application may perform a read operation on each memory cell connected to a read word line. As shown in FIG. 6b, for example, data in the three memory cells in the 1^{st} row is read. A specific read operation process is as follows: Each bit line BL is pre-charged to a third voltage, for example, a half voltage between "0" and "1". All the write word lines WWL1, WWL2, and WWL3 are set to a second voltage, for example, "0", so that the first transistor connected to each write word line WWL is turned off. A selected read word line RWL is set to the first voltage, for example, "1", so that a second transistor connected to the selected read and write word line RWL is turned on. For example, the read word line RWL1 is set to "1", so that second transistors in the memory cells in the 1^{st} row are turned on. Another read word line RWL is set to the second voltage, for example, "0", so that a second transistor connected to the another read word line RWL is turned off. For example, read word lines RWL2 and RWL3 are set to "0", so that second transistors in memory cells in the 2^{nd} row and the 3^{rd} row are turned off. A voltage change of each bit line BL is amplified through a sense amplifier. Specifically, for a memory cell whose stored data is "0", a voltage of a bit line BL remains unchanged. For example, if voltages of bit lines BL1 and BL3 remain unchanged, data stored in the 1^{st} and 3^{rd} memory cells in the 1^{st} row may be read as "0" ("R0"). For a memory cell whose stored data is "1", a voltage of a bit line BL increases. For example, if a voltage of the bit line BL2 increases, data stored in the 2^{nd} memory cell in the 1^{st} row may be read as "1" ("R1").

The foregoing describes the read and write operations of the memory circuit by using the memory circuit in which a memory cell 01 includes a single-gate transistor and a dual-gate transistor. A difference in read and write operations of the memory circuit in which a memory cell 01 includes two dual-gate transistors lies in that each write back gate WBG is set to a fixed voltage, to regulate leakage of each first transistor. In addition, fixed voltages loaded to each write back gate WBG in different operations may be the same or may be different. For example, in the standby stage, each write back gate WBG is set to the second voltage, for example, "0", to reduce leakage of the first transistor. When the write operation is performed, each write back gate WBG is set to the first voltage, for example, "1", so that the first transistor can be quickly turned on to write data.

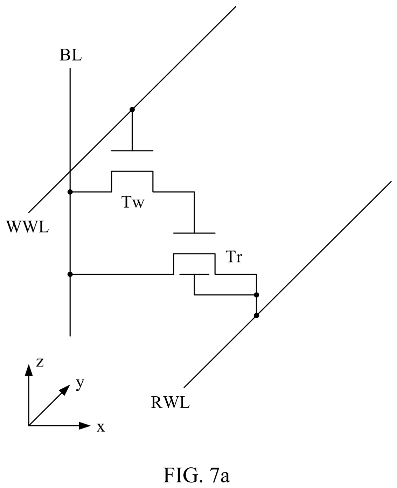

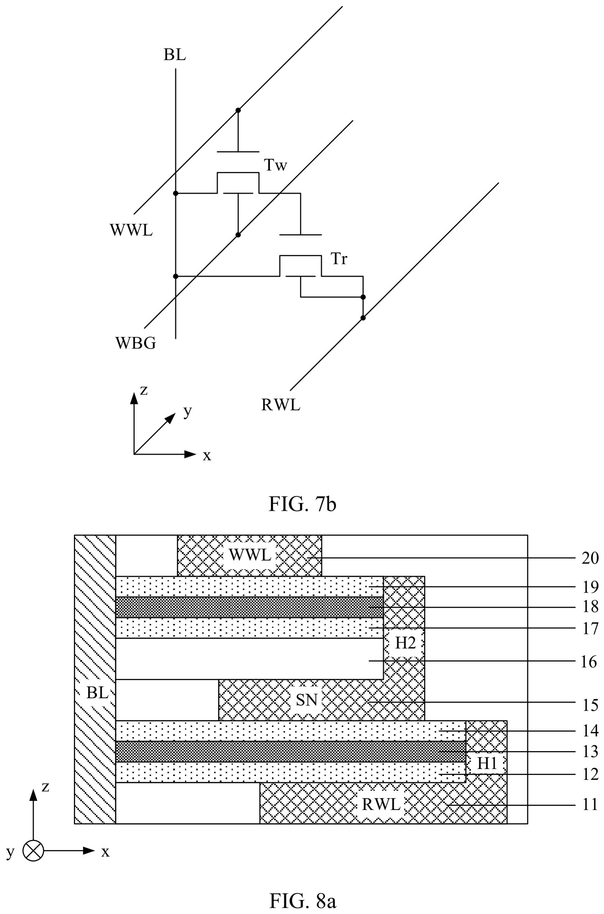

FIG. 7a is a diagram of stacking of a memory cell in the memory circuit according to an embodiment of this application. FIG. 7b is another diagram of stacking of a memory cell in the memory circuit according to an embodiment of this application.

As shown in FIG. 7a and FIG. 7b, in this embodiment of this application, to reduce an area of the memory cell 01, the first transistor Tw and the second transistor Tr that form the memory cell 01 may be stacked on a substrate. In this case, the plurality of write word lines WWLs and the plurality of read word lines RWLs may be arranged in a first direction y parallel to the substrate, and the plurality of bit lines BLs may be arranged in a second direction z perpendicular to the substrate. FIG. 7a is described by using an example in which the first transistor Tw is a single-gate transistor. As shown in FIG. 7b, when the first transistor Tw is a double-gate transistor, the write back gates WBGs may also be arranged in the first direction y parallel to the substrate.

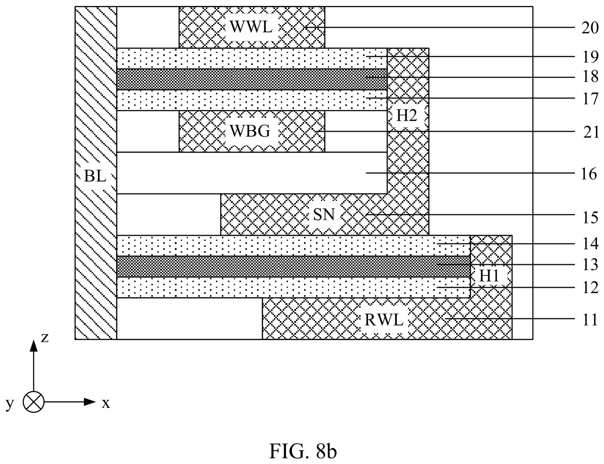

FIG. 8a is a diagram of a structure of a memory cell in the memory circuit in an xz direction according to an embodiment of this application. FIG. 8b is another diagram of a structure of a memory cell in the memory circuit in an xz direction according to an embodiment of this application.

As shown in FIG. 8a and FIG. 8b, in a memory cell 01, a second transistor Tr is disposed on a substrate, a first transistor Tw may be stacked on the second transistor Tr. In other words, the first transistor Tw is stacked on the second transistor Tr, and the first transistor Tw and the second transistor Tr may be located on a same side of a connected bit line BL. In the figure, an example in which the first transistor Tw and the second transistor Tr are located on a right side of the bit line BL is used for description. Alternatively, in a memory cell 01, a second transistor Tr may be stacked on a first transistor Tw. This is not limited herein. The following uses an example in which the first transistor Tw is stacked on the second transistor Tr for description.

As shown in FIG. 8a and FIG. 8b, for ease of routing, the first control electrode of the second transistor Tr may be set as a top gate, and the second control electrode of the second transistor Tr may be set as a back gate. In other words, the first control electrode of the second transistor Tr is located above the first electrode and the second electrode of the second transistor Tr, and the second control electrode of the second transistor Tr and the read bit line RWL are both located below the first electrode and the second electrode of the second transistor. Specifically, the second transistor Tr may include a first gate layer 11, a first gate dielectric layer 12, a first oxide semiconductor layer 13, a second gate dielectric layer 14, and a second gate layer 15 that are sequentially stacked on the substrate. The first gate layer 11 includes the second control electrode of the second transistor Tr and the read word line RWL, the second gate layer 15 includes the first control electrode of the second transistor Tr as an SN, the first oxide semiconductor layer 13 includes the first electrode, a channel, and the second electrode of the second transistor Tr, and the second electrode of the second transistor Tr is connected to the second control electrode of the second transistor Tr through a first interconnection metal structure H1.

As shown in FIG. 8a, when the first transistor Tw is a single-gate transistor, the first transistor Tw may be of a top-gate structure. To be specific, the first control electrode of the first transistor Tw and the write word line WWL are both located above the first electrode and the second electrode of the first transistor Tw. Specifically, the first transistor Tw may include a third gate dielectric layer 17, a second oxide semiconductor layer 18, a fourth gate dielectric layer 19, and a third gate layer 20 that are sequentially stacked on the second transistor Tr. In addition, an insulation layer 16 is further disposed between the first transistor Tw and the second transistor Tr. The third gate layer 20 includes the first control electrode of the first transistor Tw and the write word line WWL, the second oxide semiconductor layer 18 includes the first electrode, a channel, and the second electrode of the first transistor Tw, and the second electrode of the first transistor Tw is connected to the first control electrode of the second transistor Tr through a second interconnection metal structure H2.

As shown in FIG. 8b, when the first transistor Tw is a double-gate transistor, the first control electrode of the first transistor Tw may be a top gate, and the second control electrode of the first transistor Tw may be a back gate. To be specific, the first control electrode of the first transistor Tw and the write word line WWL are both located above the first electrode and the second electrode of the first transistor Tw, and the second control electrode of the first transistor Tw and the write back gate WBG are both located below the first electrode and the second electrode of the first transistor Tw. Specifically, the first transistor Tw may include a fourth gate layer 21, a third gate dielectric layer 17, a second oxide semiconductor layer 18, a fourth gate dielectric layer 19, and a third gate layer 20 that are sequentially stacked on the second transistor Tr. In addition, an insulation layer 16 is further disposed between the first transistor Tw and the second transistor Tr. The third gate layer 20 includes the first control electrode of the first transistor Tw and the write word line WWL, the fourth gate layer 21 includes the second control electrode of the first transistor Tw and the write back gate WBG, the second oxide semiconductor layer 18 includes the first electrode, a channel, and the second electrode of the first transistor Tw, and the second electrode of the first transistor Tw is connected to the first control electrode of the second transistor Tr through a second interconnection metal structure H2.

As shown in FIG. 8a and FIG. 8b, in the memory cell 01, the first interconnection metal structure H1 and the second interconnection metal structure H2 may be disposed on a same side (a right side in the figure) of stacked film layers (the film layers include the first gate layer 11, the first gate dielectric layer 12, the first oxide semiconductor layer 13, the second gate dielectric layer 14, the second gate layer 15, the insulation layer 16, the third gate dielectric layer 17, the second oxide semiconductor layer 18, the fourth gate dielectric layer 19, and the third gate layer 20). The bit line BL is vertically disposed on another side (a left side in the figure) of the film layers, and the bit line BL is connected to the first electrode of the first transistor Tw and the first electrode of the second transistor Tr.

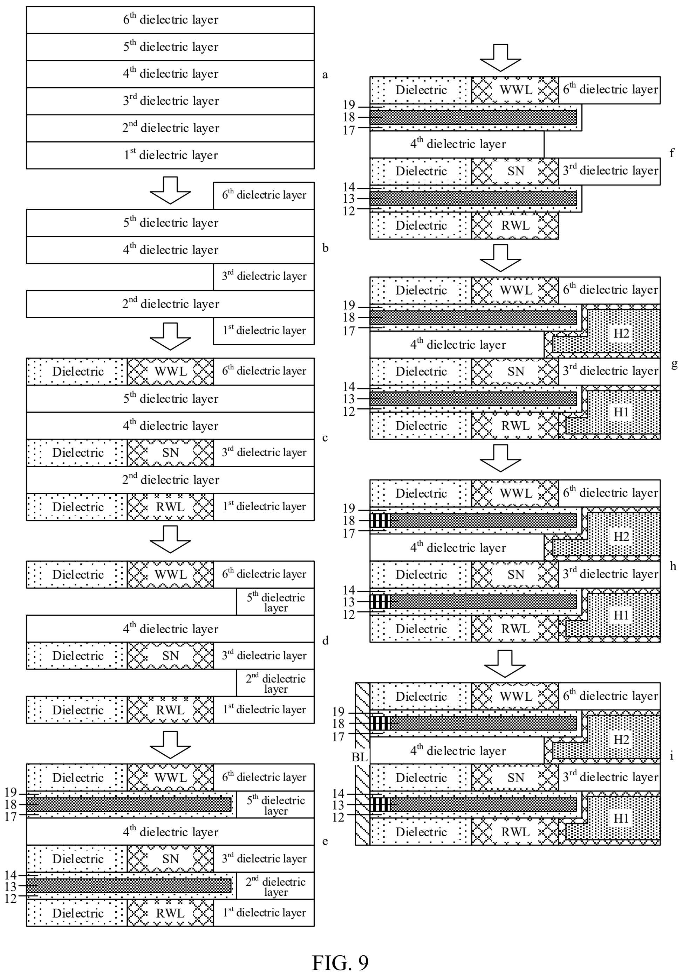

FIG. 9 is a diagram of a structure of the memory cell having the structure shown in FIG. 8a after each step in a preparation process is completed.

As shown in FIG. 9, the structure of the memory cell shown in FIG. 8a is used as an example. The memory cell of the memory circuit provided in this embodiment of this application may be prepared by using the following technical process, and the technical process specifically includes the following steps.
(1) As shown in a in FIG. 9, a plurality of dielectric layers are epitaxially grown. For example, six dielectric layers may be formed by using materials such as SiO, SiN, AlO, Si, and SiGe.
(2) As shown in b in FIG. 9, a part of the plurality of dielectric layers are selectively etched on one side of the dielectric layers. For example, a 1^{st} dielectric layer, a 3^{rd} dielectric layer, and a 6^{th} dielectric layer may be selectively etched rightward by using an atom-level etch (atom-level etch, ALE) process.
(3) As shown in c in FIG. 9, the first gate layer 11, the second gate layer 15, and the third gate layer 20 are formed through one-step deposition, and then a dielectric is formed through two-step deposition. The first gate layer 11 includes the second control electrode of the second transistor Tr and the read word line RWL, the second gate layer 15 includes the first control electrode of the second transistor Tr as an SN, and the third gate layer 20 includes the first control electrode of the first transistor Tw and the write word line WWL.
(4) As shown in d in FIG. 9, another part of the plurality of dielectric layers are selectively etched on the same side of the dielectric layers. For example, a 2^{nd} dielectric layer and a 5^{th} dielectric layer may be selectively etched rightward by using the ALE.
(5) As shown in e in FIG. 9, the first gate dielectric layer 12, the second gate dielectric layer 14, the third gate dielectric layer 17, and a fourth gate dielectric layer 19 are formed through one-step deposition, and then the first oxide semiconductor layer 13 and the second oxide semiconductor layer 18 are formed through two-step deposition. The first oxide semiconductor layer 13 includes the first electrode, the channel, and the second electrode of the second transistor Tr, and the second oxide semiconductor layer 18 includes the first electrode, the channel, and the second electrode of the first transistor Tw.
(6) As shown in f in FIG. 9, another part of the plurality of dielectric layers are selectively etched on another side of the dielectric layers. For example, the 1^{st} dielectric layer, the 2^{nd} dielectric layer, the 4^{th} dielectric layer, and the 5^{th} dielectric layer may be selectively etched leftward in another direction by using the ALE.
(7) As shown in g in FIG. 9, a metal is deposited, to form the first interconnection metal structure H1 used to connect the second electrode of the second transistor Tr and the second control electrode of the second transistor Tr, and form the second interconnection metal structure H2 used to connect the second electrode of the first transistor Tw and the first control electrode of the second transistor Tr. Specifically, the first interconnection metal structure H1 and the second interconnection metal structure H2 may include one or more film layers. This is not limited herein.
(8) Optionally, as shown in h in FIG. 9, doping may be performed on a left side of the first oxide semiconductor layer 13 and the second oxide semiconductor layer 18, and the doping may improve subsequent contact performance between a bit line BL and an oxide semiconductor material.
(9) As shown in i in FIG. 9, a metal is deposited on one side of the plurality of dielectric layers to form a bit line BL used to connect the first electrode of the first transistor Tw and the first electrode of the second transistor Tr.

The foregoing describes the memory cell preparation process by using a memory circuit in which a memory cell 01 includes a single-gate transistor and a dual-gate transistor. A difference in a preparation process of the memory circuit in which a memory cell 01 includes two dual-gate transistors lies in that: A dielectric layer is added, that is, when a part of the dielectric layers are selectively etched for the first time, an etched dielectric layer is added, and when each gate layer is formed through one-step deposition, a fourth gate layer may be further formed, where the fourth gate layer includes the second control electrode of the first transistor Tw and a write back gate WBG that are connected to each other.

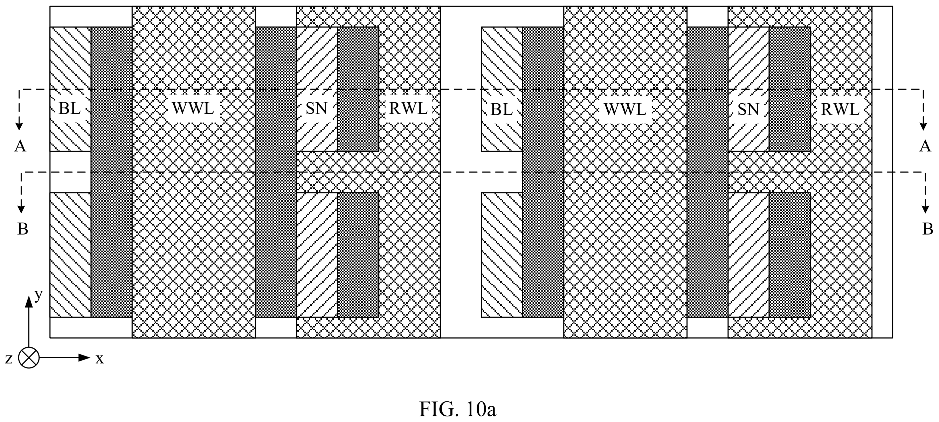

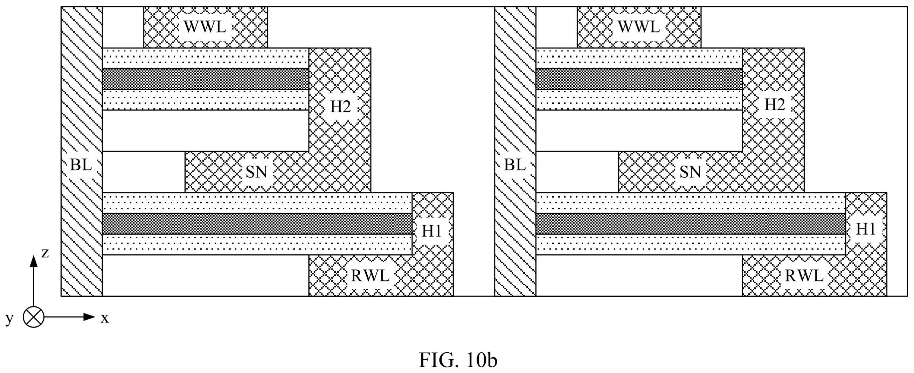

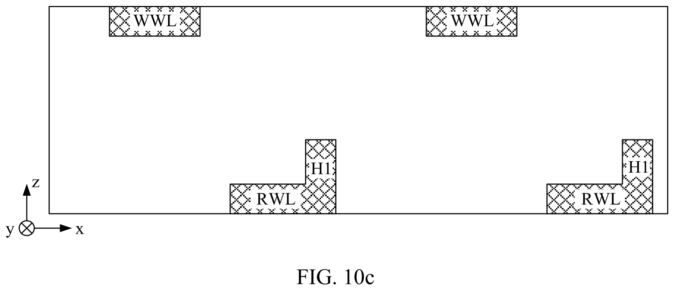

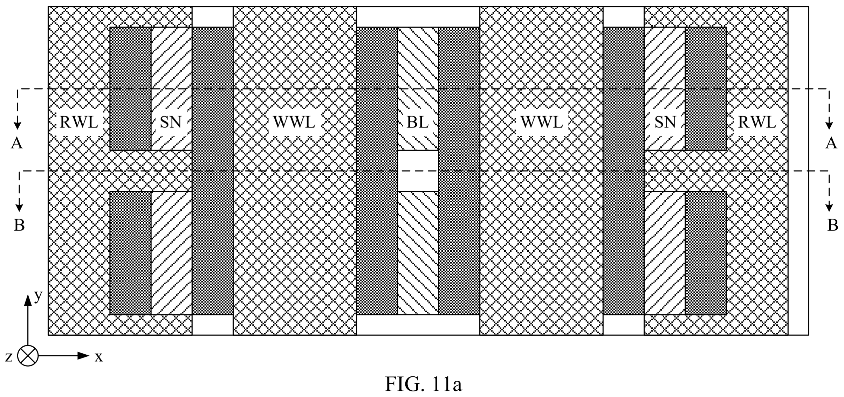

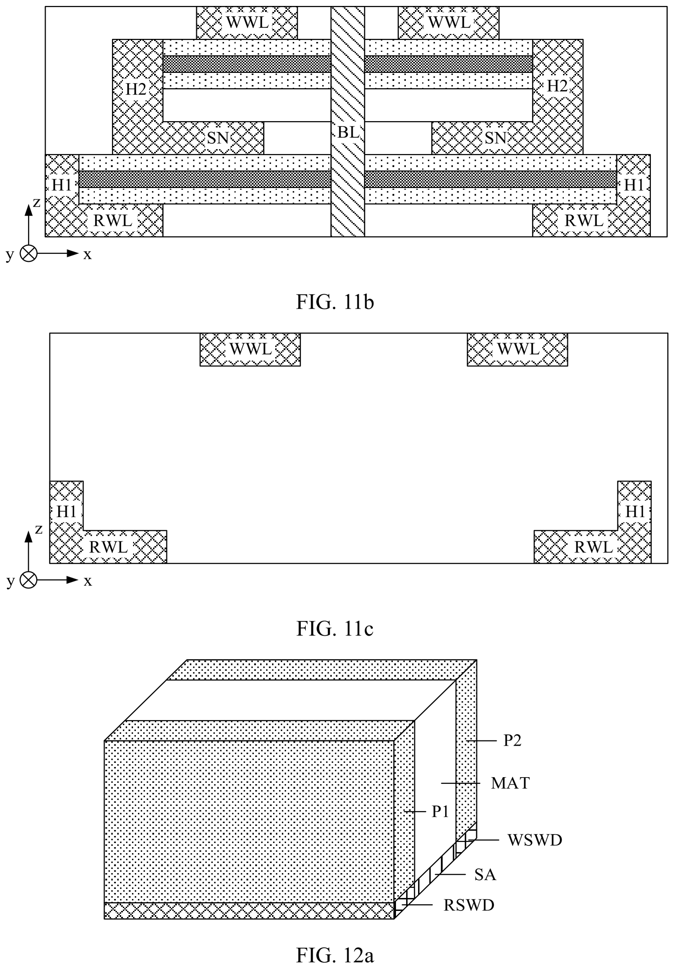

FIG. 10a is a diagram of a structure of the memory circuit in an xy direction according to an embodiment of this application. FIG. 10b is a diagram of a cross-sectional structure in an AA direction in FIG. 10a. FIG. 10c is a diagram of a cross-sectional structure in a BB direction in FIG. 10a. FIG. 11a is another diagram of the structure of the memory circuit in the xy direction according to an embodiment of this application. FIG. 11b is a diagram of a cross-sectional structure in the AA direction in FIG. 11a. FIG. 11c is a diagram of a cross-sectional structure in the BB direction in FIG. 11a.

In this embodiment of this application, to implement three-dimensional array storage, the memory cells in the memory circuit may form a plurality of memory layers stacked on the substrate, and each memory layer may include a plurality of memory cells arranged in an array. As shown in FIG. 10a and FIG. 11a, at a memory layer, memory cells in each row are arranged in an extension direction of the read word line RWL and the write word line WWL, namely, the first direction y, and memory cells in each column are arranged in the third direction x perpendicular to the first direction y. In each row of memory cells, the memory cells 01 may be connected to a same read word line RWL and a same write word line WWL. The bit line BL extends in a direction perpendicular to the memory layer, namely, the second direction z. Therefore, at different memory layers, memory cells 01 located in a same position in the second direction z may be connected to a same bit line BL. FIG. 10a and FIG. 11a are described by using 2*2 memory cells as an example.

As shown in FIG. 10a to FIG. 10c, in some embodiments of this application, memory cells in each row at a memory layer may be arranged in a same manner. In other words, memory cells in each row and each column are arranged in a same direction, and at the memory layer, the memory cells are arranged in a mosaic (mosaic) form.

As shown in FIG. 11a to FIG. 11c, in some other embodiments of this application, to reduce area overheads of the memory layer and improve array storage density, memory cells 01 in every two adjacent rows at the memory layer may be arranged in a mirror manner, and two memory cells 01 in adjacent columns share a same bit line BL. In other words, in each row of memory cells, the memory cells are arranged in a same direction. At the memory layer, two memory cells in adjacent columns are arranged in the mirror manner, and the memory cells are arranged in a back-to-back (back to back) form.

The foregoing describes how to implement three-dimensional array storage by using the memory circuit in which a memory cell 01 includes a single-gate transistor and a dual-gate transistor. A difference in implementing three-dimensional array storage by the memory circuit in which a memory cell 01 includes two dual-gate transistors lies in that: A dielectric layer is added, that is, when a part of the dielectric layers are selectively etched for the first time, an etched dielectric layer is added, and when each gate layer is formed through one-step deposition, the fourth gate layer may be further formed, where the fourth gate layer includes the second control electrode of the first transistor Tw and the write back gate WBG that are connected to each other. A write back gate WBG whose extension direction is the same as that of the read word line RWL and the write word line WWL is added. In other words, the write back gate is arranged in the first direction y. In each row of memory cells, the memory cells 01 may be further connected to a same write back gate WBG. In addition, the write back gates WBGs may be connected to each other.

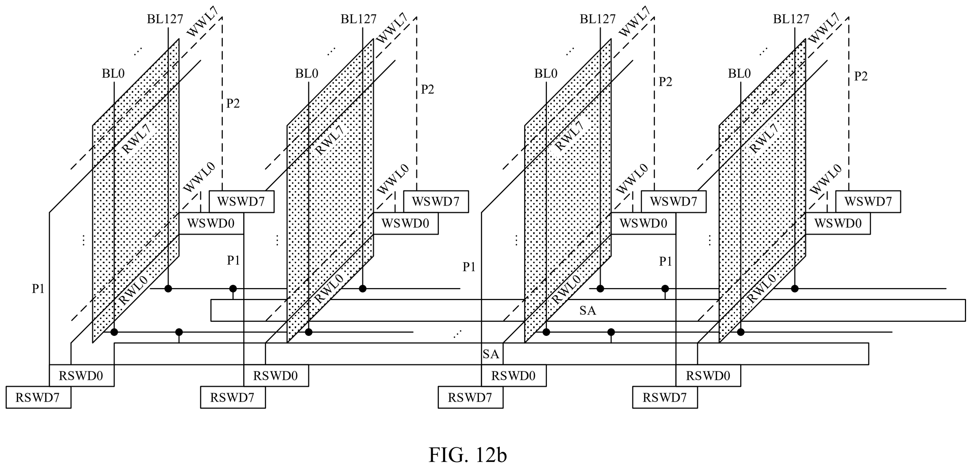

FIG. 12a is a diagram of an overall structure of a peripheral circuit of the memory circuit according to an embodiment of this application. FIG. 12b is a diagram of a specific structure of the peripheral circuit of the memory circuit according to an embodiment of this application.

As shown in FIG. 12a and FIG. 12b, in this embodiment of this application, the peripheral circuit may be further integrated around a plurality of memory layers of the memory circuit. The peripheral circuit may specifically include: a first lead line P2 configured to lead down (pick down) the plurality of write word lines WWLs and a second lead line P1 configured to pick down the plurality of read word lines RWLs, a sense amplifier SA that is disposed below the plurality of memory layers MATs and that is connected to the plurality of bit lines BLs, a write sub-word line driver WSWD that is disposed on one side of the sense amplifier SA and that is connected to the plurality of write word lines WWLs through the first lead line P2, and a read sub-word line driver RSWD that is disposed on another side of the sense amplifier SA and that is connected to the plurality of read word lines RWLs through the second lead line P1, where the leads are respectively disposed on two sides of the plurality of memory layers MATs. The read sub-word line driver RSWD is disposed below the second lead line P1, and the write sub-word line driver WSWD is disposed below the first lead line P2, so that an area of the peripheral circuit can be reduced, and storage density can be improved.

In this embodiment of this application, the plurality of memory layers MATs share the sense amplifier SA, and different memory cells are selected by using the write sub-word line driver WSWD and the read sub-word line driver RSWD to perform a read operation.

Specifically, in response to a write operation, the write sub-word line driver WSWD may control a selected write word line WWL to be set to the first voltage, to control a first transistor Tw connected to the selected write word line WWL to be turned on, and control another write word line WWL to be set to a second voltage, to control a first transistor Tw connected to the another write word line WWL to be turned off; the read sub-word line driver RSWD may control all the read word lines RWLs to be set to the second voltage, to control second transistors Tr connected to all the read word lines RWLs to be turned off; and the sense amplifier circuit SA may control, based on data that needs to be written, each bit line BL to be set to the first voltage or the second voltage.

Specifically, in response to a read operation, the sense amplifier SA may control each bit line BL to be pre-charged to the third voltage, namely, the half voltage; the write sub-word line driver WSWD may control all the write word lines WWLs to be set to the second voltage, to control first transistors Tw connected to all the write word lines WWLs to be turned off; the read sub-word line driver RSWD may control a selected read word line RWL to be set to the first voltage, to control a second transistor Tr connected to the selected read word line RWL to be turned on, and control another read word line RWL to be set to the second voltage, to control a second transistor Tr connected to the another read word line RWL to be turned off; and the sense amplifier circuit SA may amplify a voltage change of each bit line BL, to read stored data.

The foregoing describes the peripheral circuit of the memory circuit by using the memory circuit in which a memory cell 01 includes a single-gate transistor and a dual-gate transistor. A difference in a peripheral circuit of the memory circuit in which a memory cell 01 includes two dual-gate transistors lies in that a gate driver connected to each write back gate is added, and the gate driver may control each write back gate to be set to a fixed voltage.

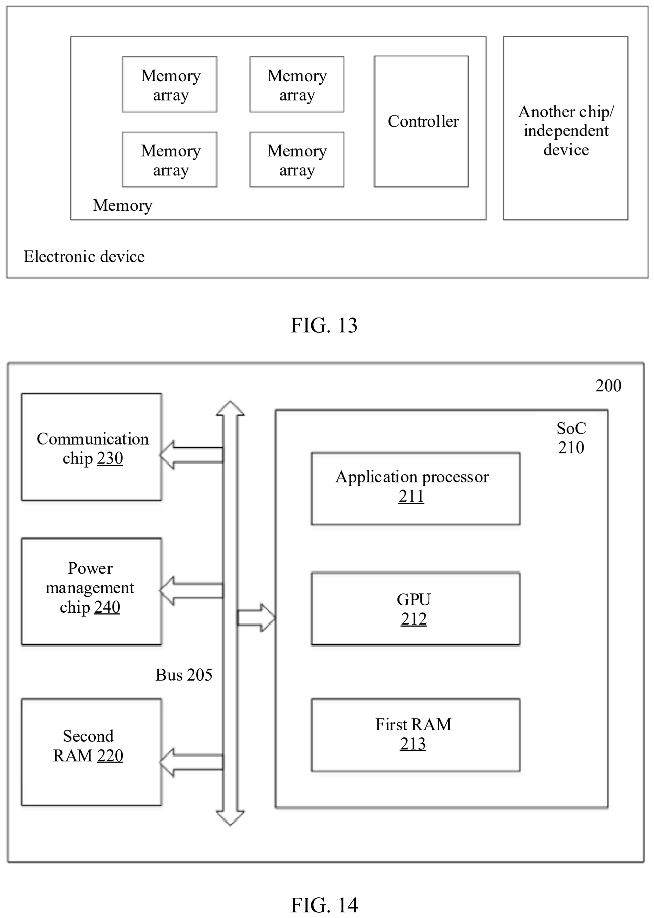

Based on a same inventive concept, an embodiment of this application further provides a memory. As shown in FIG. 13, the memory includes a controller and the memory circuit provided in embodiments of this application, and the controller is configured to access the memory circuit.

Based on a same inventive concept, an embodiment of this application further provides an electronic device. As shown in FIG. 13, the electronic device includes a circuit board (not shown in FIG. 13) and the memory provided in embodiments of this application. The memory is electrically connected to the circuit board, and the electronic device may further include another chip or an independent device.

As shown in FIG. 14, an electronic device 200 may be a terminal device, for example, a mobile phone, a tablet computer, or a smart band, or may be a personal computer (personal computer, PC), a server, a workstation, or the like. The electronic device 200 includes a bus 205 and a system on chip (System on Chip, SoC) 210 connected to the bus 205. The SoC 210 may be configured to process data, for example, process data of an application, process image data, and cache temporary data. In an implementation, the SoC 210 may include an application processor (application processor, AP) 211 configured to process the application, a graphics processing unit (Graphics Processing Unit, GPU) 212 configured to process the image data, and a first RAM 213 configured to cache high-speed data. The first RAM 213 may be a static random access memory (Static Random Access Memory, SRAM), an embedded flash (embedded flash, eflash), or the like. The AP 211, the GPU 212, and the first RAM 213 may be integrated into one die (die), or may be separately disposed in a plurality of dies. The electronic device 200 may further include a second RAM 220 connected to the SoC 210 through the bus 205. The second RAM 220 may be a dynamic random access memory (Dynamic Random Access Memory, DRAM). The second RAM 220 may be configured to store volatile data, for example, temporary data generated by the SoC 210. A storage capacity of the second RAM 220 is usually greater than that of the first RAM 213, but a read speed is usually slower than that of the first RAM 213. In addition, the electronic device 200 may further include a communication chip 230 and a power management chip 240 that are connected to the SoC 210 through the bus 205. The communication chip 230 may be configured to process a protocol stack, or perform processing such as amplification and filtering on an analog radio frequency signal, or implement the foregoing functions at the same time. The power management chip 240 may be configured to supply power to another chip. In an implementation, the SoC 210 and the second RAM 220 may be packaged in a packaging structure, for example, 2.5D (dimension) or 3D packaging is used, to obtain a faster inter-chip data transmission rate.

It is clear that a person skilled in the art can make various modifications and variations to this application without departing from the scope of this application. This application is intended to cover these modifications and variations of this application provided that they fall within the scope of protection defined by the claims of this application and their equivalent technologies.

## Claims

1. A memory circuit, comprising a plurality of memory cells, a plurality of write word lines, a plurality of read word lines, and a plurality of bit lines, wherein
at least one of the plurality of memory cells comprises a first transistor and a second transistor, and the second transistor is a double-gate transistor; and
in the memory cell, a first electrode of the first transistor and a first electrode of the second transistor are both connected to a same bit line in the plurality of bit lines, a second electrode of the first transistor is connected to a first control electrode of the second transistor, a first control electrode of the first transistor is connected to one of the plurality of write word lines, and a second electrode and a second control electrode of the second transistor are both connected to one of the plurality of read word lines.

2. The memory circuit according to claim 1, wherein the memory circuit further comprises a substrate, the plurality of write word lines and the plurality of read word lines are arranged in a first direction parallel to the substrate, and the plurality of bit lines are arranged in a second direction perpendicular to the substrate; and
the first transistor and the second transistor are stacked on the substrate, and the first transistor and the second transistor are stacked on a same side of the connected bit line.

3. The memory circuit according to claim 2, wherein the second transistor is disposed on the substrate, and the first transistor is stacked on the second transistor;
the first control electrode of the first transistor is located above the first electrode and the second electrode of the first transistor;
the first control electrode of the second transistor is a top gate and is located above the first electrode and the second electrode of the second transistor; and
the second control electrode of the second transistor is a back gate and is located below the first electrode and the second electrode of the second transistor.

4. The memory circuit according to claim 3, wherein the memory cell comprises a first gate layer, a first gate dielectric layer, a first oxide semiconductor layer, a second gate dielectric layer, a second gate layer, an insulation layer, a third gate dielectric layer, a second oxide semiconductor layer, a fourth gate dielectric layer, and a third gate layer that are sequentially stacked on the substrate;
the first gate layer comprises the second control electrode of the second transistor and the read word line;
the second gate layer comprises the first control electrode of the second transistor;
the third gate layer comprises the first control electrode of the first transistor and the write word line;
the first oxide semiconductor layer comprises the first electrode, a channel, and the second electrode of the second transistor, and the second electrode of the second transistor is connected to the second control electrode of the second transistor through a first interconnection metal structure;
the second oxide semiconductor layer comprises the first electrode, a channel, and the second electrode of the first transistor, and the second electrode of the first transistor is connected to the first control electrode of the second transistor through a second interconnection metal structure;
the first interconnection metal structure and the second interconnection metal structure are disposed on a same side of each film layer; and
the first electrode of the first transistor and the first electrode of the second transistor are both connected to the bit line disposed on another side of each film layer.

5. The memory circuit according to any one of claims 2 to 4, comprising a plurality of memory layers stacked on the substrate, wherein the plurality of memory cells comprised in each of the plurality of memory layers are arranged in an array;
in each row of memory cells that are arranged in an array at the memory layer, the memory cells are connected to a same read word line and a same write word line; and
at different memory layers, memory cells that are located in a same position in the second direction are connected to a same bit line.

6. The memory circuit according to claim 5, wherein at the memory layer, memory cells in every two adjacent rows are arranged in a mirror manner, and two memory cells whose columns are adjacent share a same bit line.

7. The memory circuit according to claim 5, wherein each row of memory cells at the memory layer are arranged in a same manner.

8. The memory circuit according to any one of claims 1 to 7, further comprising a plurality of write back gates, wherein
the first transistor is a double-gate transistor, and the second control electrode of the first transistor is connected to one of the plurality of write back gates.

9. The memory circuit according to any one of claims 5 to 8, further comprising: a write sub-word line driver, a read sub-word line driver, and a sense amplifier, wherein
the sense amplifier is disposed below the plurality of memory layers and is connected to the plurality of bit lines, the write sub-word line driver is disposed on one side of the sense amplifier and is connected to the plurality of write word lines through a first lead line, and the read sub-word line driver is disposed on another side of the sense amplifier and is connected to the plurality of read word lines through a second lead line.

10. The memory circuit according to claim 9, wherein in response to a write instruction, the write sub-word line driver is configured to: control a selected write word line to be set to a first voltage, to control a first transistor connected to the selected write word line to be turned on, and control another write word line to be set to a second voltage, to control a first transistor connected to the another write word line to be turned off; the read sub-word line driver is configured to control all the read word lines to be set to the second voltage, to control second transistors connected to all the read word lines to be turned off; and the sense amplifier is configured to control, based on data that needs to be written, each bit line to be set to the first voltage or the second voltage.

11. The memory circuit according to claim 9 or 10, wherein in response to a read instruction, the sense amplifier is configured to control each bit line to be pre-charged to a third voltage; the write sub-word line driver is configured to control all the write word lines to be set to the second voltage, to control first transistors connected to all the write word lines to be turned off; the read sub-word line driver is configured to: control a selected read word line to be set to the first voltage, to control a second transistor connected to the selected read word line to be turned on, and control another read word line to be set to the second voltage, to control a second transistor connected to the another read word line to be turned off; and the sense amplifier is configured to amplify a voltage change of each bit line.

12. The memory circuit according to claim 8, further comprising a gate driver, wherein
the gate driver is configured to control each write back gate to be set to a fixed voltage.

13. A memory, comprising a controller and the memory circuit according to any one of claims 1 to 12, wherein the controller is configured to access the memory circuit.

14. An electronic device, comprising a circuit board and the memory according to claim 13, wherein the memory is electrically connected to the circuit board.

15. A memory circuit preparation method, comprising:
forming a plurality of memory cells, a plurality of write word lines, a plurality of read word lines, and a plurality of bit lines, wherein at least one of the plurality of memory cells comprises a first transistor and a second transistor, and the second transistor is a double-gate transistor; and in the memory cell, a first electrode of the first transistor and a first electrode of the second transistor are both connected to a same bit line in the plurality of bit lines, a second electrode of the first transistor is connected to a first control electrode of the second transistor, a first control electrode of the first transistor is connected to one of the plurality of write word lines, and a second electrode and a second control electrode of the second transistor are both connected to one of the plurality of read word lines.

16. The preparation method according to claim 15, wherein forming the plurality of memory cells, the plurality of write word lines, the plurality of read word lines, and the plurality of bit lines comprises:
epitaxially growing a plurality of dielectric layers;
selectively etching a part of the plurality of dielectric layers on one side of the dielectric layers, and then forming a first gate layer, a second gate layer, and a third gate layer, wherein the first gate layer comprises the second control electrode of the second transistor and the read word line, the second gate layer comprises the first control electrode of the second transistor, and the third gate layer comprises the first control electrode of the first transistor and the write word line;
selectively etching another part of the plurality of dielectric layers on the same side of the dielectric layers, and then forming a first oxide semiconductor layer and a second oxide semiconductor layer, wherein the first oxide semiconductor layer comprises the first electrode, a channel, and the second electrode of the second transistor, and the second oxide semiconductor layer comprises the first electrode, a channel, and the second electrode of the first transistor;
selectively etching another part of the plurality of dielectric layers on another side of the dielectric layers, and then forming a first interconnection metal structure used to connect the second electrode of the second transistor and the second control electrode of the second transistor, and form a second interconnection metal structure used to connect the second electrode of the first transistor and the first control electrode of the second transistor; and
forming, on one side of the plurality of dielectric layers, a bit line used to connect the first electrode of the first transistor and the first electrode of the second transistor.

17. The preparation method according to claim 16, wherein when the first gate layer, the second gate layer, and the third gate layer are formed, the method further comprises: forming a fourth gate layer, wherein the fourth gate layer comprises the second control electrode of the first transistor and a write back gate that are connected to each other.
